# EUROPÄISCHE PATENTSCHRIFT

(11) **EP 0 514 384 B1**
(45) Veröffentlichungstag und Bekanntmachung des Hinweises auf die Patenterteilung: **16.08.1995**
(21) Anmeldenummer: 91901683.2
(22) Anmeldetag: 10.01.1991
(51) Int. Cl.: C23C 16/50

(54) **VORRICHTUNG ZUM BEHANDELN VON SUBSTRATEN IN EINEM DURCH MIKROWELLEN ERZEUGTEN, GASGESTÜTZTEN PLASMA**
DEVICE FOR TREATING SUBSTRATES IN A GAS-BASED PLASMA PRODUCED BY MICROWAVES
PROCEDE DE TRAITEMENT DE SUBSTRATS DANS UN PLASMA PRODUIT PAR DES MICRO-ONDES ET MAINTENU AVEC UN GAZ

(30) Priorität: 09.02.1990 DE 4003904
(43) Veröffentlichungstag der Anmeldung: 25.11.1992
(73) Patentinhaber: ROBERT BOSCH GMBH, 70442 Stuttgart (DE)
(72) Erfinder: SCHNEIDER, Guenter, D-7122 Besigheim (DE); BENZ, Gerhard, D-7030 Boeblingen (DE)
(86) Internationale Anmeldenummer: DE9100018
(87) Internationale Veröffentlichungsnummer: WO9112353

(56) Entgegenhaltungen:
- EP-A- 0 279 895
- FR-A- 2 328 025
- Patent Abstracts of Japan, Band 12, nr. 344 (C-528) (3191), 16. September 1988;& JP-A-63103089 (CANON INC) 07. Mai 1988

## Beschreibung

### Stand der Technik

Die Erfindung betrifft eine Vorrichtung zum Behandeln von Substraten, insbesondere zum Aufbringen einer Schutzschicht auf die Oberfläche optischer Reflektoren, in einem durch Mikrowellen erzeugten, gasgestützten Plasma nach der Gattung des Hauptanspruchs. Eine gattungsgemäße Vorrichtung ist aus dem Patent Abstract of Japan, Band 12, nr. 344 (C-528) (3191), 16.9.1988 (JP-A 63 10 3089) bekannt, bei der ein trommelförmig ausgebildeter und einen Gaseinlaß aufweisender Vakuum-Rezipient zur Aufnahme der zu behandelnden Substrate vorgesehen ist. Der Vakuum-Rezipient besitzt ein Durchtrittsfenster für die von einem außerhalb des Rezipienten angeordneten Generator erzeugte Mikrowellenenergie, wobei die Mikrowellenenergie durch eine sich an das Fenster anschließende Mikrowellenantenne in das Innere des Rezipienten eingespeist wird.

Durch die DE-PS 26 25 448 ist ferner ein Verfahren bekannt, wie optische Reflektoren, vorzugsweise aluminiumbedampfte Scheinwerferreflektoren, durch eine Plasmapolymerschicht vor Korrosion geschützt werden können. Dazu werden die Reflektoren in einem Vakuum-Rezipienten einem monomeren Dampf organischer Verbindungen, vorzugsweise einer siliziumorganischen Substanz, ausgesetzt und die Schutzschicht durch Polymerisation aus der Dampfphase mit Hilfe der Strahlung aus einer unselbständigen Glimmentladung unter Verwendung eines Wolfram-Glühdrahtes abgeschieden. Die mit diesem Verfahren erzielbare Abscheiderate reicht häufig nicht aus, um die für eine erhöhte Schwitzwasserbeständigkeit notwendige Mindestschichtdicke zu erzielen. Weiter ist zu beachten, daß nicht nur eine Mindestschichtdicke abgeschieden wird, sondern daß an besonders exponierten Stellen, z.B. an Planflächen des Reflektors, eine maximale Schichtdicke nicht überschritten wird. Ab einer Grenzschichtdicke von ca. 70 nm kann es sonst zur Ausbildung von störenden Interferenzfarben kommen, weil die Phasenbedingung für destruktive Interferenz von blauem Licht erfüllt wird (Brechungsindex der Schutzschicht n 1,5).

Damit besteht der Reflektor die Qualitätsanforderungen nicht. Deshalb darf das Verhältnis zwischen größter Schutzschichtdicke, z. B. an Vorderflächenplanstellen, und kleinster Dicke, z. B. im Lampenhalsbereich, auch bei tiefgeformten Reflektoren maximal ca. 2,8 : 1 betragen. Andernfalls ist die geforderte Schwitzwasserbeständigkeit über mehrere hundert Stunden ohne optische Beeinträchtigung durch bunte Interferenzfarben nicht erreichbar.

Diese Bedingung kann mit dem angegebenen Verfahren (Wolfram-Glühdraht - unselbständige Glimmentladung) häufig nicht erfüllt werden. Der Grund für die in manchen Fällen unzulängliche Schichtdickenverteilung liegt in dem relativ hohen, für eine wirtschaftliche Abscheidung der Schichten notwendigen Prozeßdruck in der Größenordnung von 10⁻³ - 10⁻² mbar, bei dem die freie Weglänge der reaktiven Spezies kleiner als die Tiefenausdehnung des zu beschichtenden Reflektors ist. Ein weiterer Nachteil dieses Verfahrens ist der relativ hohe Aufwand durch den Verbrauch von Wolfram-Glühdrähten.

Aus der Literatur sind Plasma-Erzeugungsverfahren mit besonders hohem Wirkungsgrad bekannt, die grundsätzlich eine Druckreduzierung bis auf ca. 10⁻⁵ mbar zulassen. Dazu gehört die Elektron-Zyklotron-Resonanz-Plasmaerzeugung (ECR) bei Anregungsfrequenzen im Gigaherz-Bereich. Da die freie Weglinie der reaktiven Spezies bei diesen niedrigen Prozeßdrücken viel größer als die Tiefenausdehnung der zu beschichtenden Teile wird, ist eine drastische Verbesserung der Schichtdickenverteilung auf den Reflektoranzen zu erwarten.

Durch die DE-OS 37 05 666 ist eine Einrichtung zur Erzeugung eines Plasmas und zur Behandlung von Substraten darin bekanntgeworden. Das mit Hilfe von Mikrowellen erzeugte Plasma dient dazu, ein Substrat zu beschichten, das sich in einem evakuierbaren Gehäuse befindet. Mit Hilfe von Dauermagneten, die in der Nähe des zu beschichtenden Substrats angebracht werden, ist es möglich, innerhalb des Gehäuses eine Elektron-Zyklotron-Resonanz zu erzeugen, die ein örtlich gezieltes Zünden des Plasmas gestattet (in der DE-OS 37 05 666 werden die Grundlagen der Elektron-Zyklotron-Resonanz ausführlich behandelt, so daß hier nicht darauf eingegangen werden muß). Zur Miktrowelleneinkopplung ist in einer Seitenwand des Gehäuses ein sich in Längsrichtung desselben erstreckendes, großes, rechteckiges Fenster ausgebildet, das durch eine Quarzglasscheibe hermetisch verschlossen ist. Dazu muß das Gehäuse über nahezu seine ganze Länge aufgeschnitten werden. Hinter dem Fenster ist in sehr kleinem Abstand zu den zu beschichtenden Substraten eine in sich geschlossene Magnetkonfiguration angebracht, um dort ein ECR-Plasma zu erzeugen. Die Vorrichtung ist auch zur Beschichtung ausgeprägter dreidimensionaler Gegenstände geeignet.

### Vorteile der Erfindung

Die erfindungsgemäße Vorrichtung mit den kennzeichnenden Merkmalen des Anspruchs 1 hat demgegenüber den Vorteil, daß durch die Verwendung einer Magnetbank, eine örtlich begrenzte Elektron-Zyklotron-Resonanz ermöglicht wird, die eine homogene Verteilung des Plasmas über die gesamte Länge des Vakuum-Rezipienten bei sehr niedrigem Prozeßdruck bewirkt. Dies gestattet eine optimale Nutzung des im Rezipienten vorhandenen Raumes für die Unterbringung der zu beschichteten Substrate. Dies gilt insbesondere für Substrate, die in bekannter Weise in die Planetenkäfige eines trommelförmigen Beschickungswagens eingesetzt sind, welcher durch eine Tür in den Rezipienten eingefahren wird. Dabei ist die Beschichtungsquelle in einem relativ großen Abstand von den zu beschichtenden Substraten angeordnet, was im Hinblick auf eine günstige Schichtdickenverteilung auf tief geformten Substraten ebenfalls von Vorteil ist. Außerdem läßt sich die Beschichtung innerhalb eines großen Raumwinkels durchführen. Dadurch wird die notwendige Beschichtungszeit pro Charge bei gleichzeitig geringem Prozeßdruck deutlich kürzer.

Durch die in den Unteransprüchen aufgeführten Maßnahmen sind vorteilhafte Weiterbildungen und Verbesserungen der im Hauptanspruch angegeben Vorrichtung möglich. Besonders vorteilhaft ist die Mikrowellenantenne, die sich im Innern des Rezipienten an das Fenster anschließt, als Hohlleiter auszuführen, welcher sich in raumsparender Weise in Richtung der Längsachse des Vakuum-Rezipienten erstreckt.

Zur Reduktion der Mikrowellenleistungsdichte an dem Vakuumfenster ist es günstig, dort eine Querschnittstransformation des Mikrowellenhohlleiters vorzunehmen und diesen mit einem vergrößerten Querschnitt anzukoppeln. Dieser Hohlleiter schützt gleichzeitig die Innenseite des Vakuumfenster vor Verschmutzen, wenn die Substrate vor ihrer Plasmapolymerbeschichtung einer Metallbedampfung, bei spielsweise einer Aluminiumbedampfung, ausgesetzt werden. Die Magnetbank wird vorteilhaft aus Dauermagneten zusammengesetzt, in der Weise, daß benachbarte Magnetreihen eine wechselnde Polarität aufweisen.

Besonders vorteilhaft ist es, das Fenster in einem eine Öffnung der Stirnwand verschließenden, abnehmbaren Deckel anzubringen. Der Rezipient selbst bleibt auf diese Weise frei von Durchbrüchen für das Mikrowellenfenster. Der Deckel ist zweckmäßigerweise im Zentrum der Stirnwand angeordnet. So kann auch die Beschichtungsquelle im Zentrum oder nahe des Zentrums des Rezipienten mit ausreichendem Abstand von den zu beschichtenden Substraten angebracht werden.

### Zeichnung

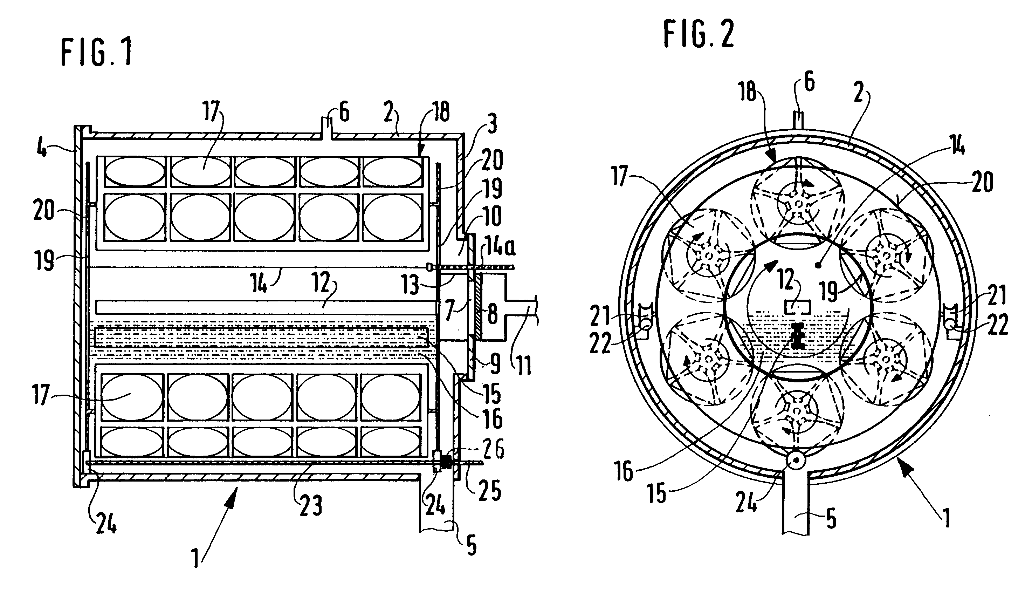

Einzelheiten und weitere Merkmale der Erfindung ergeben sich aus der Zeichnung und der nachfolgenden Beschreibung wobei in der Zeichnung ein Ausführungsbeispiel der Erfindung dargestellt ist. Es zeigen Figur 1 eine schematisch dargestellte Vorrichtung zum Behandeln von Scheinwerferreflektoren in einem Längsschnitt, Figur 2 die Vorrichtung nach Figur 1 in einem Querschnitt.

### Beschreibung des Ausführungsbeispiels

In den Figuren ist mit 1 ein Vakuum-Rezipient bezeichnet, der ein langgestrecktes, zylindrisches Gehäuse 2 hat, das stirnseitig durch je eine Wand 3 bzw. 4 abgeschlossen ist. Die Stirnwand 4 ist als hermetisch verschließbare Tür ausgebildet, die in geöffneter Stellung das Beschicken des Rezipienten 1 mit den zu behandelnden Substraten gestattet. Das Gehäuse 2 kann über einen Stutzen 5, der an eine nicht gezeichnete Pumpe angeschlossen ist, evakuiert werden. Die Beschichtung der Substrate erfolgt mittels eines monomeren Dampfes, der über einen Einlaßstutzen 6 in das Gehäuse 2 eingelassen und dort ionisiert wird. Das Monomer bzw. die Monomergemische sind vorzugsweise die in der DE-PS 2 625 448 angegebenen chemischen Verbindungen aus der Gruppe der Siloxane und der Silane.

Die andere Stirnwand 3 des Gehäuses 2 ist mit einem Durchtrittsfenster 7 für Mikrowellenenergie versehen, das durch eine Scheibe 8 aus für Mikrowellenstrahlung durchlässigem Material, beispielsweise Quarzglas, verschlossen ist. Das Fenster 7 ist in einem abnehmbaren Deckel 9 ausgebildet, der eine Zugangsöffnung 10 in das Gehäuseinnere verschließt. Die Öffnung 10 ist im Ausführungsbeispiel im Zentrum der Stirnwand 3 und das Fenster 7 im Zentrum des Deckels 9 angeordnet.

Die von einem Mikrowellengenerator 11 erzeugte Strahlung wird durch die Scheibe 8 und das Fenster 7 über eine Mikrowellenantenne 12 eingekoppelt. Prinzipiell sind für die Mikrowellenantenne viele Ausführungsformen denkbar, wie Hornstrahler, Schlitzantennen oder Antennen mit Koppelstiften. Die Mikrowellenantenne ist, wie aus Figur 1 ersichtlich, als zentral angeordnetes Rohr ausgebildet, das sich in Richtung der Längsachse des Gehäuses 2 erstreckt. Mit ihrem kappenförmig ausgebildeten Endstück 13 ist die Mikrowellenantenne 12 an der Innenseite des Deckels 9 einseitig befestigt, wobei dieser Hohlleiter 13 das Fenster 7 und die Scheibe 8 vollständig abdeckt. Dies verhindert, daß sich an der Scheibe Niederschläge bilden können, welche die eingespeisten Mikrowellen reflektieren und dadurch die Leistung beeinträchtigen. Ein solcher Schutz der Scheibe ist insbesondere dann wichtig, wenn die zu beschichtenden Substrate zuvor im gleichen Rezipienten mit einer Metallschicht, insbesondere einer Aluminiumschicht, bedampft werden, wie dies beispielsweise für Scheinwerferreflektoren obligatorisch und üblich ist. Ein zu einer solchen Verdampfungsanlage gehörender Verdampferdraht ist in den Figuren dargestellt und mit 14 bezeichnet. Er ist an eine außerhalb des Rezipienten befindliche Stromquelle angeschlossen. Eine Stromzuführungsleitung 14a für den Verdampferdraht 14 ist außerhalb des Fensters 7 und der Scheibe 8 durch den Deckel 9 hindurchgeführt.

Parallel zu der Mikrowellenantenne 12 ist in geringem Abstand zu dieser eine stabförmige Magnetbank 15 angeordnet. Mit Hilfe dieser Magnetbank wird ein geeignetes Magnetfeld erzeugt, das die Elektron-Zykloron Resonanzbedingung erfüllt. Dabei werden die durch Ionisation der Monomermoleküle im Mikrowellenfeld erzeugten Elektronen aufgrund der Lorenzkraft auf spiralförmige Bahnen um die Magnetfeldlinien gezwungen. Dadurch wird die Ionisierungswahrscheinlichkeit für die Gasmoleküle bei dem angestrebten niedrigen Prozeßdruck erhöht. Die Magnetbank 15 ist an einen nachstehend näher beschriebenen Beschickungswagen befestigt.

Im einzelnen hat die Magnetbank einen stabförmigen Träger aus weichmagnetischem Material mit zwei einander gegenüberliegenden parallelen Planflächen, an denen im Ausführungsbeispiel jeweils drei Einzelmagnetreihen in gleichem Abstand voneinander angeordnet sind, deren Polenden sich bezüglich der Polarität von den Polenden der jeweils benachbarten Einzelmagnetreihe unterscheiden.

Bei Erfüllung der ECR-Bedingung (magnetische Flußdichte B = 87,5 mT bei einer Mikrowellenfrequenz f = 2,45 GHz) wird in den beiden schraffiert eingezeichneten Zonen 16 ein Plasma gezündet. Wird ein polymerisierbares Monomer wie Hexamethyldisiloxan (HMDS(O)), eingeleitet, so kann damit eine Glimmpolymerschutzschicht abgeschieden werden.

Das Prinzip ist also, anstelle eines Wolfram-Glühdrahtes eine geeignete Magnetbank in den Vakuum-Rezipienten einzubauen. Damit entfällt die seither notwendige elektrische Kontaktierung für die Heizung und für die Hochspannungszuführung. Über an sich bekannte Mikrowellenabstrahlelemente wird in die Anlage Mikrowellenenergie eingespeist und ist somit "latent" vorhanden. Dabei wird der Prozeßdruck so niedrig eingestellt, daß aufgrund des Paschen-Gesetzes noch kein Plasmazünden über übliche Stoßlawinen-Prozesse erfolgt. Nur in der Nähe der Magnetbank, wo die Zyklotron-Resonanz-Bedingung erfüllt ist, erfolgt eine "resonante Plasmaentladung". Somit wird die Plasmaverteilung über die Anlagenlänge nicht durch eine in der Praxis nur schwer realisierbare homogene Mikrowellenfeldverteilung, sondern durch ein geeignetes Magnetfeld erzeugt. Bezogen auf den Prozeßdruck bedeutet dieses Konzept, daß die Vorrichtung bei Drücken p kleiner als 10⁻³ mbar betrieben werden sollte. Wie erwartet, ermöglicht der niedrige Prozeßdruck eine bessere Schichtdickenverteilung der Glimmpolymerschutzschicht auf tiefen Reflektoren: Der experimentielle Wert für das Schichtdickenverhältnis zwischen Vorderflächenplanstelle und Lampenhalsbereich beträgt < 2 : 1.

Bei den zu beschichtenden Substraten handelt es sich um Scheinwerferreflektoren 17. Davon sind jeweils mehrere in bekannter Weise in die eine zylindrische Außenkontur aufweisenden Planetenkäfige 18 eingesetzt, die ihrerseits zwischen zwei je eine kreisförmige Mittenaussparung 19 aufweisenden Scheiben 20 drehbar gelagert sind. Die Scheiben 20 sind in einem nicht dargestellten Rahmen drehbar angebracht, welcher mit zwei einander diametral gegenüberliegenden Rollenanordnungen 21 versehen ist. Jeder Rollenanordnung ist eine an der Innenseite des Gehäuses 2 angebrachte Laufschiene 22 zugeordnet. Auf diesen Schienen läßt sich der die Teile 18 und 20 aufweisende Beschickungswagen mit Hilfe der Rollen 21 freitragend in das Gehäuse 2 einfahren und aus diesem ausfahren.

Der Antrieb der beiden Scheiben erfolgt durch je eine auf einer Welle 23 sitzenden Rolle (oder Zahnrad) 24, die am Außenumfang der Scheibe angreift. Von der Drehbewegung der Scheiben 20 kann auch der Antrieb der Käfige 18 abgeleitet werden. Der Antrieb der Welle 23 erfolgt durch eine Motorwelle 25 über eine Kupplung 26.

Wie aus den Figuren deutlich ersichtlich ist, nutzt die Vorrichtung zur Unterbringung der Beschichtungsquelle 12, 15 den ohnehin vorhandenen freien Raum im Innern des Beschickungswagens. Dadurch entsteht für die Teile 12, 15 kein zusätzlicher Platzbedarf im Gehäuse 2. Wie aus Figur 2 hervorgeht, deckt das von der Beschichtungsquelle 12, 15 erzeugte Plasma 16 einen Raumwinkel von ca. 180 ° ab. Dadurch werden mindestens zwei Reihen von Reflektoren gleichzeitig beschichtet, was die Beschichtungszeit deutlich verkürzt. Ein Schutz der Scheibe 8 durch zusätzliche Blenden oder dergleichen vor dem Bedampfen mit Aluminium entfällt, da der Mikrowellenhohlleiter die Scheibe abdeckt. Durch die beschriebene Anordnung der Beschichtungsquelle können auch bestehende Anlagen problemlos auf das ECR-Verfahren umgerüstet werden.

## Patentansprüche

1. Vorrichtung zum Behandeln von Substraten, insbesondere zum Aufbringen einer Schutzschicht auf die Oberfläche optischer Reflektoren, in einem durch Mikrowellen erzeugten, gasgestützten Plasma, mit einem vorzugsweise trommelförmig ausgebildeten, einen Gaseinlaß aufweisenden Vakuum-Rezipienten zur Aufnahme der zu behandelnden Substrate, welcher ein durch ein Quarzglas oder dergleichen verschlossenes Durchtrittsfenster für die von einem außerhalb des Rezipienten angeordneten Generator erzeugte Mikrowellenenergie hat, wobei die Mikrowellenenergie durch eine sich an das Fenster anschließende Mikrowellenantenne in das Innere des Rezipienten eingespeist wird, dadurch gekennzeichnet, daß im Vakuum-Rezipienten (1, 2) im Zusammenwirken mit der Mikrowellenantenne (12) eine Magnetbank (15) zur Erzeugung örtlicher Elektron-Zyklotron-Resonanzen angeordnet ist.

2. Vorrichtung nach Anspruch 1, dadurch gekennzeichnet, daß die Mikrowellenantenne (12) aus einem Hohlleiter besteht, der sich in Richtung der Längsachse des Vakuum-Rezipienten (1, 2) erstreckt.

3. Vorrichtung nach Anspruch 1 oder 2, dadurch gekennzeichnet daß die Mikrowellenantenne (12) mit ihrem einen Ende an der Innenseite des Vakuum-Rezipienten (1, 2) befestigt ist.

4. Vorrichtung nach einem der vorhergehenden Ansprüche, dadurch gekennzeichnet, daß die Mikrowellenantenne (12) ein Hohlleiterstück (13) hat, welches das im Vakuum-Rezipienten (1, 2) ausgebildete Fenster (7) von innen her abdeckt.

5. Vorrichtung nach Anspruch 1, dadurch gekennzeichnet, daß sich die Magnetbank (15) parallel zur Mikrowellenantenne (12) erstreckt.

6. Vorrichtung nach Anspruch 5, dadurch gekennzeichnet, daß die Magnetbank (15) aus einem Dauermagnetsystem besteht, das einen stabförmigen Träger aus einem weichmagnetischen Material mit zwei parallelen, einander gegenüberliegenden Planflächen hat, an denen jeweils Einzelmagnetreihen in gleichem Abstand voneinander angeordnet sind, deren Polenden sich bezüglich der Polarität von den Polenden der jeweils benachbarten Einzelmagnetreihe unterscheiden.

7. Vorrichtung nach einem der vorhergehenden Ansprüche, dadurch gekennzeichnet, daß das den Durchtritt der Mikrowellenenergie in das Innere des Rezipienten (1, 2) gestattende Fenster (7) in einer Stirnwand (3) des Rezipienten ausgebildet ist.

8. Vorrichtung nach Anspruch 7, dadurch gekennzeichnet, daß das Fenster (7) im Zentrumsbereich der Stirnwand (3) angeordnet ist.

9. Vorrichtung nach Anspruch 7 oder 8, dadurch gekennzeichnet, daß das Fenster (7) in einem eine Öffnung (10) der Stirnwand (3) verschließenden, abnehmbaren Deckel (9) ausgebildet ist.

10. Vorrichtung nach einem der vorhergehenden Ansprüche, dadurch gekennzeichnet, daß in dem Vakuum-Rezipienten (1, 2) wenigstens ein elektrisch beheizter Verdampferdraht (14) für eine primäre Metallbedampfung der zu beschichtenden Substrate angeordnet ist, dessen Stromzuführungsleitungen (14a) durch die das Fenster (7) enthaltende Stirnwand (3) des Rezipienten hindurchgeführt sind.

11. Vorrichtung nach Anspruch dadurch gekennzeichnet, daß Durchführungsbohrungen für die Stromzuführungsleitungen (14a) innerhalb des das Fenster (7) aufweisenden Deckels (9) angebracht sind.

## Claims

1. Apparatus for treating substrates, in particular for applying a protective layer to the surface of optical reflectors, in a microwave-generated gas-supported plasma, comprising a vacuum bell jar, which is of drum-type design and has a gas inlet, for receiving the substrates to be treated, which vacuum bell jar has a passage window sealed by quartz glass or the like for the microwave energy generated by a generator disposed outside the bell jar, the microwave energy being injected into the interior of the bell jar by a microwave aerial adjoining the window, characterised in that a magnet bank (15) for generating local electron cyclotron resonance in interaction with the microwave aerial (12) is disposed in the vacuum bell jar (1, 2).

2. Apparatus according to Claim 1, characterised in that the microwave aerial (12) comprises a waveguide which extends in the direction of the longitudinal axis of the vacuum bell jar (1, 2).

3. Apparatus according to Claim 1 or 2, characterised in that one end of the microwave aerial (12) is attached to the inside of the vacuum bell jar (1, 2).

4. Apparatus according to one of the preceding claims, characterised in that the microwave aerial (12) has a waveguide section (13) which covers the window (7) formed in the vacuum bell jar (1, 2) from the inside.

5. Apparatus according to Claim 1, characterised in that the magnet bank (15) extends parallel to the microwave aerial (12).

6. Apparatus according to Claim 5, characterised in that the magnet bank (15) comprises a permanent magnet system which has a bar-type support composed of magnetically soft material having two parallel, mutually opposite plane surfaces on which individual rows of magnets are each disposed equidistantly from one another, the pole ends of said individual rows of magnets being different in terms of polarity from the pole ends of the respectively adjacent individual row of magnets.

7. Apparatus according to one of the preceding claims, characterised in that the window (7) which makes possible the passage of the microwave energy into the interior of the bell jar (1, 2) is formed in an end wall (3) of the bell jar.

8. Apparatus according to Claim 7, characterised in that the window is disposed in the central region of the end wall (3).

9. Apparatus according to Claim 7 or 8, characterised in that the window (7) is formed in a demountable lid (9) which seals an opening (10) of the end wall (3).

10. Apparatus according to one of the preceding claims, characterised in that at least one electrically heated evaporator wire (14) for a primary metal evaporation coating of the substrates to be coated is disposed in the vacuum bell jar (1, 2), the current supply leads (14a) of said evaporator wire (14) being passed through the end wall (3) of the bell jar containing the window (7).

11. Apparatus according to Claim 10, characterised in that the feedthrough holes for the current supply leads (14a) are provided inside the lid (9) having the window (7).

## Revendications

1. Dispositif pour traiter des substrats, en particulier pour mettre une couche de protection sur la surface de réflecteurs optiques dans un plasma maintenu avec un gaz et produit par des micro-ondes dans un récipient sous vide constitué de préférence en forme de tambour, présentant une entrée pour le gaz et qui sert à recevoir les substrats à traiter, récipient qui a une fenêtre de passage pour l'énergie des micro-ondes produite par un générateur disposé à l'extérieur du récipient, fenêtre qui est fermée par une vitre en quartz ou analogue, l'énergie des micro-ondes étant fournie à l'intérieur du récipient, par une antenne à micro-ondes raccorde à la fenêtre, dispositif caractérisé en ce que dans le récipient sous vide (1, 2) est disposé, en coopération avec l'antenne à micro-ondes (12), un banc magnétique (15) qui sert à produire des résonances gyromagnétiques locales des électrons.

2. Dispositif selon la revendication 1, caractérisé en ce que l'antenne à micro-ondes (12) consiste en un conducteur creux qui s'étend dans le sens de l'axe longitudinal du récipient sous vide (1, 2).

3. Dispositif selon la revendication 1 ou 2, caractérisé en ce que l'antenne à micro-ondes (12) est fixée par une extrémité au côté intérieur du récipient sous vide (1, 2).

4. Dispositif selon l'une des revendications précédentes, caractérisé en ce que l'antenne à micro-ondes (12) a une pièce conductrice creuse (13) qui recouvre de l'intérieur la fenêtre constituée dans le récipient sous vide (1, 2).

5. Dispositif selon la revendication 1, caractérisé en ce que le banc magnétique (15) s'étend en parallèle à l'antenne à micro-ondes (12).

6. Dispositif selon la revendication 5, caractérisé en ce que le banc magnétique (15) consiste en un système d'aimants permanents qui a un support en forme de barreau en un matériau magnétique doux avec deux surfaces planes parallèles, situées en regard l'une de l'autre, sur lesquelles sont disposées respectivement des rangées d'aimants individuels à la même distance, aimants dont les extrémités polaires sont différentes de la polarité des extrémités polaires des rangées d'aimants individuels respectivement voisines.

7. Dispositif selon l'une des revendications précédentes, caractérisé en ce que la fenêtre (7) qui permet le passage de l'énergie des micro-ondes à l'intérieur du récipient (1, 2), est constituée dans une paroi frontale (3) du récipient.

8. Dispositif selon la revendication 7, caractérisé en ce que la fenêtre (7) est disposée dans la zone centrale de la paroi frontale (3).

9. Dispositif selon la revendication 7 ou 8, caractérisé en ce que la fenêtre (7) est constituée dans un couvercle (9) que l'on peut enlever et qui ferme une ouverture (10) de la paroi frontale (3).

10. Dispositif selon l'une des revendications précédentes, caractérisé en ce que, dans le récipient sous vide (1, 2), on dispose au moins un fil de vaporisation (14) chauffé électriquement, pour une vaporisation métallique primaire des substrats à garnir d'une couche, les lignes (14a) d'amenée du courant passant à travers la paroi frontale (3) du récipient contenant la fenêtre (7).

11. Dispositif selon la revendication 10, caractérisé en ce que l'on dispose des perçages de passage pour les lignes (14a) d'amenée du courant, à l'intérieur du couvercle (9) présentant la fenêtre (7).
